Europäisches Patentamt

European Patent Office

Office européen des brevets

(11) Publication number: 0 516 866 A1

# EUROPEAN PATENT APPLICATION

(21) Application number: 91107214.8

(22) Date of filing: 03.05.91

(51) Int. Cl.5: **H01L 23/538**, H01L 23/473, H01L 25/065

(43) Date of publication of application:
**09.12.92 Bulletin 92/50**

(84) Designated Contracting States:
**DE FR GB**

(71) Applicant: **International Business Machines Corporation**
**Old Orchard Road**
**Armonk, N.Y. 10504(US)**

(72) Inventor: **Bayer, Thomas**
**Hinterweilerstrasse 45**
**W-7032 Sindelfingen(DE)**
Inventor: **Greschner, Johann, Dr.**
**Tiergartenweg 14**
**W-7401 Pliezhausen(DE)**
Inventor: **Hildenbrand, Willy**
**Stützweg 3**
**W-7037 Magstadt(DE)**
Inventor: **Marquart, Bernd**
**Schillerstrasse 32**
**W-7039 Weil im Schönbuch 3(DE)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

(54) Modular multilayer interwiring structure.

(57) A modular multilayer interwiring substrate is disclosed wherein various parts of relatively small size are produced separately as 'sub-units' (1), which are finally combined to form the multilayer interwiring structure (22). Hereby each individual layer of the final structure is formed by joining a respective set of unit parts (1) in one plane. The whole multilayer substrate is then built by stacking these layers, preferably in such a manner, that a lateral displacement occurs from one layer to the other and vertical neighboured unit parts (1) will have their edges not in line. The unit parts (1) itself carry on their front and/or rear side at least one layer of conductive material (8, 9) which can be individually patterned into diverse interconnection lines (5). Throughconnections (6) from front to backside of the units (1) are performed by a desired set or a standardised array of via holes (6) or openings filled with conductive material thus revealing electric paths penetrating the units. By connecting desired throughputs (6) to the respective conduction lines (5) each unit (1) can form an individual part of a more complex multilayer interwiring structure (22).

FIG.5

The present invention discloses a new construction of multilayer substrates. More specifically this invention relates to a new type of multilayer structures which can serve as interwiring substrates, including those suitable for use in semiconductor VLSI packaging technology. By introducing a novel modular concept the new method allows flexible and inexpensive fabrication of various types of multilayer interwiring substrates. With the technique of the present invention product modifications, e.g. pertaining to outer dimensions or wiring complexity, can easily be executed by standardised process steps.

In modern computer technology, due to high performance requirements pluralities of integrated circuits are usually combined with functional units. These units may include up to hundreds of integrated circuits which are commonly placed next to each other onto the surface of a substrate component. As there are numerous data signals to transfer from and to each integrated circuit, the substrate typically comprises a dense and complex interwiring structure. Additionally, this structure must be stable against mechanical and thermal stresses since the temperature of the integrated circuits varies remarkably due to their actual activity level.

A respective structure comprising the demanded properties is realised in the well known multilayer ceramic substrate (MLC). This substrate type typically consists of alumina, whereby in many cases the alumina is compounded with other components, e.g. glass. Usually the integrated circuit semiconductor devices attached to and being in surface contact with the substrate consist of monocrystalline silicon with a thermal expansion coefficient of 2.5 X 10-6 per K. As alumina has a different expansion coefficient (5.8 X 10-6 per K) tension forces occur between substrate and the integrated device which generates heat under operation. This will result in shorter life times of the whole circuit/substrate unit. Therefore with the use of standard MLC substrates stress reduction techniques are necessary, including effective cooling, limitation of chip size and specific connection techniques, e.g. controlled collapse chip connection (C4).

During MLC fabrication different layers, carrying conduction lines for power distribution and signal transfer, are stacked to a wiring network structure comprising a plurality of horizontal and vertical interconnections. To achieve a substrate of sufficient rigidity, the whole structure is 'baked' in a sintering process. This high temperature step is critical due to a remarkable shrinking of the substrate. Hereby each individual layer, including its numerous vias for vertical wirings, must exactly maintain its geometry and orientation with respect to the other layers of the stacked structure. If sintering is not performed with precise uniformity it may cause opens and or shorts of internal conducting paths, e.g. by dislocations of the vertical contacting vias. This leads to non-recoverable defective MLC substrates, because such internal wiring faults can not be repaired.

The fabrication of modern MLC substrates requires a whole sequence of various high precision process steps, whereby preceding results typically have an impact on the outcome of the following. Due to these dependencies rework possibilities are generally limited. Accordingly, each notable modification of the MLC layout, either in size or internal wiring design, causes outstanding and expensive changes in equipment and processes. On the other hand in fabrication a substitution or renewal of toolings is usually necessary within periods of time. This frequently causes undesired alterations of parameters which can result in defective products. As rework in most cases is virtually impossible, these inherent difficulties in MLC production lead to substantial yield limitations.

The present invention as claimed is intended to deliver a new type of interwiring substrate and an improved technique for its fabrication.

The new concept discloses a modular substrate construction, wherein various parts of relatively small size are produced separately as 'subunits', which are finally combined to form the multilayer interwiring structure. Hereby the unit parts are planar pieces preferably of geometric shape (e.g. quadrangle, triangle or hexagon) which can be placed next to each other without remaining spacings - whereby it is of course not necessary that all of these units are of identical shape.

Each individual layer of the final structure is obtained by joining a respective set of unit parts in one plane. The whole multilayer substrate is then build by stacking of these layers, preferably in such a manner, that a lateral displacement occurs from one layer to the other and vertical neighboured unit parts will have their edges not in line. Hereby all units can be utilized to accomplish dense layers without gaps between individual units. On the other hand it is possible to, at least partly, select units to leave spaces or voids which then can form channels in the final multilayer substrate suitable for heat reduction, e.g. by flow of air or other coolants.

The unit parts itself consist of an insulating or semiconducting material, e.g. ceramics, glasses, glass-ceramics, silicon or composition material, carrying on their front and/or rear side at least one layer of conduction material which can be individually patterned into diverse interconnection lines. Throughconnections from front to backside of the unit are obtained by a desired set or a standardised array of via holes or openings filled with conductive material thus generating electric paths penetrating the unit. By connecting desired throughconnections to the respective conduction lines or conduction layers of front and/or backside, each unit can form an individual part of a more complex multilayer interwiring structure.

During assembly of the final multilayer interwiring structure the different units are combined e.g. by brazing or soldering techniques. For this each unit part comprises individual sets or standardised arrays of surface pads suitable for soldering or brazing and arranged to fit to the respective pads of the units above and below. Hereby simultaneously electrical interconnections between vertically neighboured unit parts are formed as desired brazing or soldering pads can be connected to the respective conduction lines or conductive layers of each unit.

Wirings between laterally neighboured unit parts of one layer of the interwiring substrate can be made by means of units in another layer, carrying conduction lines which are crossing the edges of units in another plane due to the respective displacement of the stacked layers.

The different layers of the final substrate can be electrically separated between each other by means of insulating material, e.g. $SiO_2$, $Si_3N_4$ or polyimid. Hereby the desired surface contact pads for brazing or soldering of the units remain uncovered due to respective openings or vias produced by standard techniques known in the art.

It is also possible to keep all stacked layers in a small distance from each other, i.e. without being in planar physical contact. For this brazing or soldering pads are arranged to protrude from the unit's surface in a manner that, after brazing or soldering, spaces between the unit parts remain, sufficient to keep apart conductive surface areas or surface interconnection lines of the units. Thus no insulating coverage of the units is necessary which reduces the number of process steps and, additionally, gives best electric performance due to decreased parasitic capacitances (low dielectric constant of air).

It is a specific advantage of this invention, that the modular concept allows the construction of a great variety of interwiring substrates without major alterations, neither in process nor in toolings. Modifications of magnitude can simply be overcome by adding or leaving unit parts thus changing the area of the layers. Functional alterations of the substrates, e.g. concerning additional wirings due to new and more complex integrated circuits, are also easy to obtain. For this either additional layers are appended or the combination of the unit parts is altered and/or specific unit parts of the substrate are modified as required. As with ongoing development of technology usually the substrate is only to change in part and not as a whole in general it will be sufficient in most cases to modify only few individual unit parts, keeping the majority unchanged. Thus standard unit parts can be used in a great variety of multilayer substrates.

According to the modular concept of the present invention zero-defect multilayer substrates are easy to assemble as each - less complex - sub-unit can be tested separately and only faultless parts are selected for further processing. This will result in a high quality level and raise yield rates respectively.

An additional advantage of the new concept is that, different units of individual shape and/or wiring function can be produced simultaneously and joined finally to the desired substrate. This is in decisive contrast to actual MLC fabrication, which requires a whole and contiguous sequence of high precision process steps to reach a defect-free terminal product. With the new modular technique the majority of process steps can be accomplished and optimised independently.

For a better understanding of the present invention, together with further objects and advantages, preferred embodiments of the invention are described in the following with reference to the accompanying drawings of which:

Fig. 1    is a scheme of one sub-unit of the preferred modular embodiment. Part of the unit is cut open to show details of the interior.

Fig. 2    demonstrates the preferred arrangement of surface contacts as an array and the lay-out of surface conduction lines. For comparison to prior art (MLC) technique, a respective drawing is additionally shown.

Fig. 3    shows an enlarged cross-sectional view of the sub-unit with a cut direction chosen parallel to one outer edge of the unit.

Fig. 4    is a detailed cross-sectional plot of two stacked layers of units in the preferred interwiring structure. The cut direction is the same as in Fig. 3.

Fig. 5    gives a total view of the final interwiring structure. Specific elements and features of the preferred embodiment are included.

Fig. 6    is an enlarged cross-sectional drawing of the interwiring substrate according to Fig. 5 wherein besides the stacked wiring layers 22 the basement layers 23 with terminal pins are shown.

Fig. 7    shows an alternative embodiment wherein the terminal pins are replaced by plug-in sockets which are located on the front side of the enlarged basement.

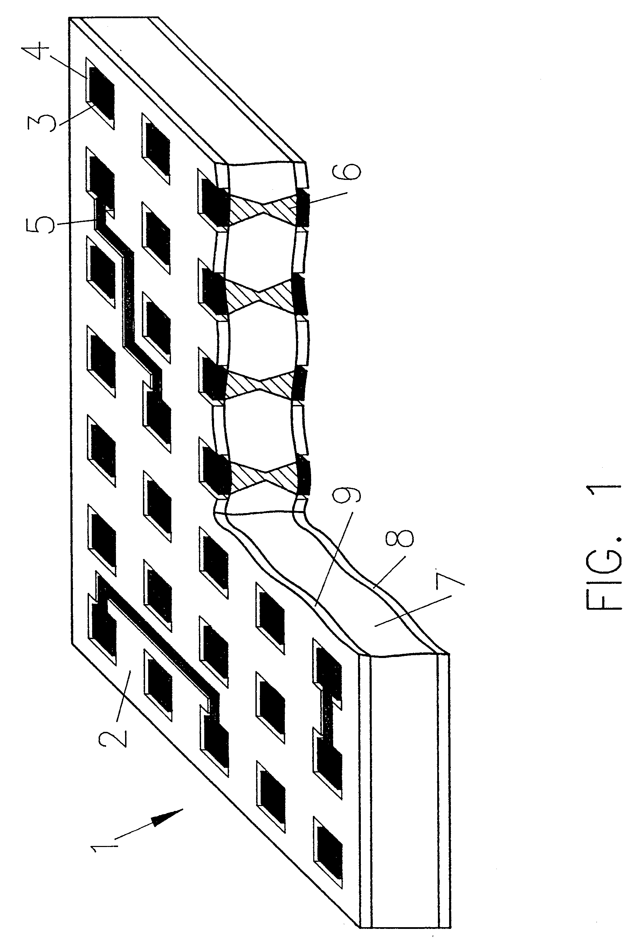

According to the inventive modular concept the new interwiring substrate consists of stacked layers which are joined together e.g. by brazing or soldering techniques. Each layer itself comprises sets of individual sub-units placed next to each other. In Fig. 1 a typical unit 1 of the preferred embodiment is shown, having a top surface 2 of square shape. Of course other forms of the units can be chosen for building layers of the final substrate. Hereby cooling channels may be generated due to locally remaining small spaces left between the units. In the preferred embodiment each layer of neighboured units constitutes a densely packed plane without remaining voids.

Each unit preferably consists of an insulating or semiconducting material 7 and comprises a set of surface contact pads 3. These pads may by individually arranged e.g. as determined by the desired vertical conduction paths to the next layer or as a standardised array. The latter is the preferred design shown in Fig. 1, wherein each surface contact pad represents the terminal area of a throughput connection 6. This generates a standardised array or matrix of throughputs, each electrically connecting the respective paired front and backside surface conduction pads. According to this uniform design the majority of the units can be produced up to this process level as identical parts. Individualisation (personalization) is then obtained by applying particular surface conduction lines 5 which interconnect specific contact pads 3.

In the preferred embodiment the units consist of monocrystalline silicon and were cut out of standard wafers used in semiconductor technology. This allows the generation of vias 6 by use of anisotropical etching which includes dry (reactive ion etching) or wet etch techniques which are well known in the art, although other methods e.g. micro drilling or LASER-beam etching or micro-electro-erosion are also conceivable. Using standard 100-oriented Si-wafers, anisotropical wet etching leaves holes having the shape of a square based pyramid. Openings are thus generated by etching simultaneously from both sides until the 'tips' of the pyramids are overlapping to an amount sufficient to assure vias of the desired width. Electrical connections from one side of the unit to the other are then formed by filling these structures with a conductive or superconducting material by means of depositing techniques as for example sputtering, (evaporating), chemical vapour deposition, plating baths or other techniques known in the art. Prior to this the walls of the throughput holes are preferably covered with a dielectric substance such as $SiO_2$ - (preferably thermal $SiO_2$) or $Si_3N_4$ to separate the conductive inner matter from the surrounding monocrystalline silicon by an insulating layer.

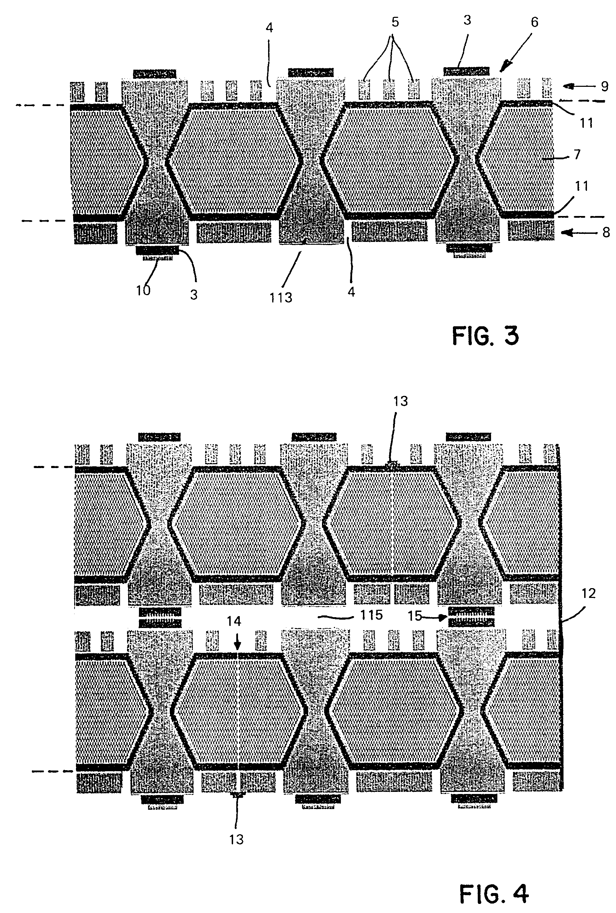

This layer can simultaneously be extended to serve as a primary coverage of the front and backside surface of the units (Fig. 3, ref. no. 11).

As presented in Fig. 1 front and backside of each unit is covered with a thin layer 8, 9 of a conductive material, e.g. metal, alloy or doped semiconductor, which can be deposited by the techniques mentioned above. For good electric performance preferably materials with low electric resistivity such as copper, aluminum-copper, tungsten-silicide or titanium-silicide or others well known in the art can be selected. For specific applications superconducting materials may also be used for the layers 8 or 9. It is of course possible to use different materials for front and backside of the unit. The surface contact pads 3 on front and backside are generally electrically insulated from the surrounding conductive layer 8, 9 e.g. by a separating space 4 which is formed by means of standard structuring techniques known in the art. This separating space is simply left out if connection of specific contact pads to the respective conduction layer 8, 9 or conduction line 5 is desired.

Surface conduction lines 5 can be formed out of the conductive layers 8, 9 preferably with standard lithographic or photolithographic techniques. In the preferred design as shown in Fig. 1 only on the frontal side 2 of the unit conduction lines are generated and the backside remains totally covered with conductive material 8 - except for the separating spaces or rings 4 needed for contact pad isolation. Other embodiments may carry conduction lines on both sides thus allowing a more complex wiring. The preferred embodiment however has the advantage that such a contiguous conductive plane serves as a field shield and/or can be used as low resistance power/ground distribution layer within the final multilayer interwiring structure.

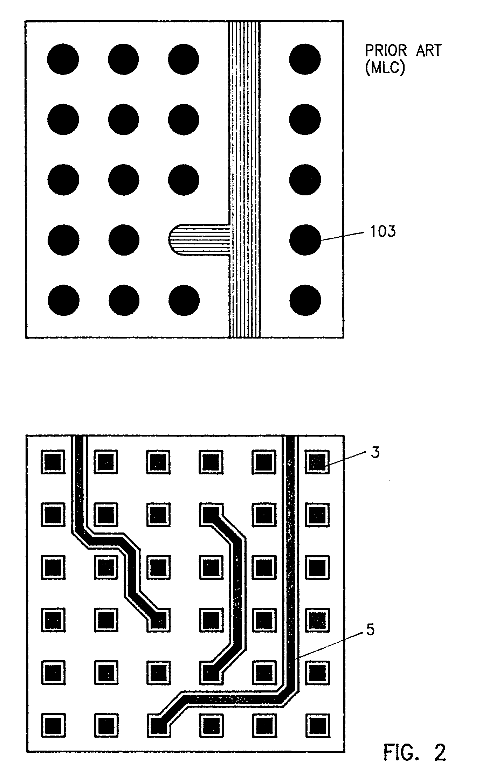

As shown in Fig. 2 surface conduction lines which interconnect specific surface contact pads are running between these pads without disturbing the matrix arrangement. This is in contrast to actual MLC techniques, wherein each interconnection line reduces the number of available contact pads as it is placed in line on the pads' grid as shown in the upper part of Fig. 2. With the use of patterning techniques out of the field of integrated circuit production it is furthermore possible to reduce the size of the conducting lines thus allowing several lines to pass between two pads (an example with three of such lines is indicated schematically in Fig. 3).

Fig. 3 shows an enlarged cross-sectional drawing of a sub-unit with a cut direction chosen parallel to a line of surface contacts of the unit. To separate the conductive layers 8, 9 and the penetrating throughconnections 6 from the silicon base material 7, the latter is covered with an insulating layer 11 prior to deposition of conductive material. This layer is preferably consisting of $SiO_2$ or $Si_3N_4$ although other dielectric materials or combinations thereof will be suitable. It is also possible to use insulating layers differing in thickness and materials for various surface parts or the walls of the vias.

In the preferred embodiment the vias 6 are generated by anisotropical wet etching of the silicon base material 7 thus showing a typical bipyramidal shape. For electrical interconnection all vias are filled with a conductive material, preferably copper due to its high electrical and thermal conductivity. The plurality of throughconnections carry on both sides surface contact pads 3 consisting of a conductive material suitable to serve as wettable soldering or brazing substratum. These pads have a thickness sufficient to keep stacked units after brazing or soldering at a small distance. Thus the pads work simultaneously as distance holders creating a space between conducting layers of vertically neighboured units. At least on one side of the unit additional conductive matter 10 is deposited on the contact pads 3, which is chosen from metals, alloys or compositions known in the art to serve as solder or brazing material. This substance is melted later in the process sequence during joining of the stacked unit-layers.

Realisation of a complex wiring network may require that on individual units specific throughconnections have no electrical contact with surface contacts of the unit above or below. For example an electrical bridging to laterally neighboured units may be desired to be formed by wirings on units only of one other layer, i.e. the respective vertically superposed lines of throughconnections in the final structure are only locally in electrical contact. For this the deposition of contact pads 3 and soldering/brazing material 10 on the terminal area of selected throughconnections (and on the corresponding areas of the throughconnections of the vertically neighboured units respectively) is omitted 113, 115.

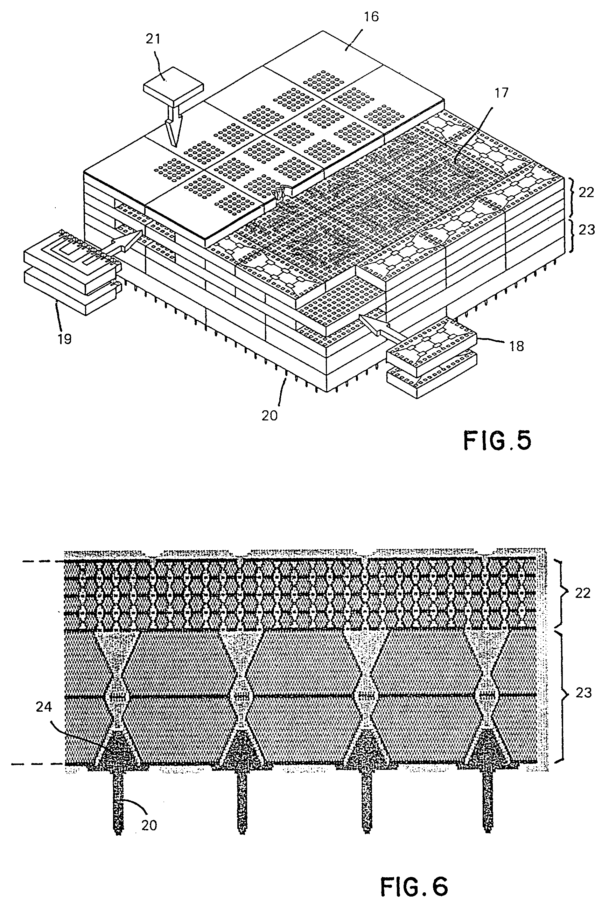

Fig. 4 is a sectional view demonstrating the joining of units. In each plane of the final structure units are placed next to each other, whereby in the preferred embodiment no voids or spaces remain. During assembly this allows an easy positioning of the units with respect to each other by directly using their sides as aligning edges 14. Units consisting of monocrystalline silicon can be cut out of thin wafer disks, whereby with modern high precision dicing tools the desired accuracy can be achieved. The layers are stacked in a manner that a lateral displacement occurs between vertically neighboured units and then connected by means of brazing or soldering pads 15. The majority of the units is preferably carrying a dense standard array of throughconnections which is in alignment to the throughconnection arrays of the neighboured layers above and below. Thus after brazing or soldering the final substrate comprises a set of vertically running linear chains of throughconnections. Due to the fact that the volume of the vias is preferably filled with copper, a grid or bundle of thermoconducting 'bars' is formed within the body of the final multilayer substrate which is capable to optimise heat distribution.

It is a specific advantage of the present invention, that with the described configuration of units being set apart by distance holders it is not necessary to cover the conductive layers 8, 9 including the surface conducting lines 5 with a non-conductive material which would otherwise be needed for insulation purposes. Hereby it should be considered that all conductive matter exposed to air must be chosen from those materials which are resistant against air induced corrosive effects.

With this design nearly all signal carrying wirings are mainly surrounded by air, i.e. being separated from each other by a medium with a dielectric constant close to one. Thus parasitic capacitances are significantly reduced, resulting in faster signal propagation and downgraded cross-over talks within the final multilayer structure.

For specific purposes an alternative embodiment with units having covered surfaces and/or surface conduction lines may be superior. There are diverse substances known in the art which are suitable as a final surface layer, e.g. polyimid, $SiO_2$, PSG or BPSG ( = $SiO_2$ including phosphorus or in addition boron). In this case at least parts of the stacked layers of the final multilayer substrate may have direct physical contact. This allows a compact connection of the layers whereby optional polishing steps may precede. Within this embodiment distance holders may be obsolete or can be formed as described above or by other structures such as protruding pins or sockets.

On the right-hand side of Fig. 4 it is shown that the sides of the multilayer substrate can be covered with a final plate or a layer 12, e.g. for surface protection. This simultaneously can have a sealing effect which prohibits undesired exchange between the surrounding atmosphere and the interior of the substrate. Similarly the terminal dicing edges of adjacent units can be sealed 13 to avoid capillary effects.

Although in Figs. 1-4 only one conductive layer 8, 9 is shown on each side of the unit it is also possible by use of standard techniques to prepare several conductive planes separated by insulating material and structured e.g. by lithographic techniques. Interconnections of individual conducting lines of these layers can be formed by means of respective vias. In this case such a unit will already represent a 'low level' multilayer interwiring structure suitable to be part of a more complex substrate as described in above embodiments.

It is also possible to include passive electronic elements such as resistors or capacitors or even active electronic elements such as diodes or transistors as parts of the units (not shown). Especially if the units consist of semiconducting material these elements can be formed directly as parts of the unit by using standard integration technologies. Thus the final multilayer interwiring substrate may already comprise electronic functionality.

The preferred embodiment of the final multilayer interwiring substrate is schematically shown in Fig. 5. The stacked layers of units 17 form the upper part 22 of the whole structure. The top layer hereby is consisting of units 16 which are carrying surface contact pads arranged to correspond to the respective integrated circuits 21, which may differ in size and/or numbers of contacts (not shown). Due to the displacement between the layers recesses occur at the sides of the substrate. These recesses can be used for units 18 which may have a specific shape if a planar side of the final multilayer substrate is desired. It is also possible to use at least one of these recesses as a female part of a plug-in system. The corresponding insertion parts 19 may comprise sets or arrays of micro contacts selected from those described in a great diversity in the art.

It is a specific advantage of the present invention that this plug-in facility can be used for various purposes. For example modifications of the inner wiring network after completion of the multilayer substrate can be made by insertion of plug-in parts 19 carrying contacts which are interconnected by means of respective conducting lines. Thus repairing or individualisation of the final interwiring substrate is possible. As the plug-in parts, especially if consisting of semiconducting material, additionally may carry passive or even active electronic devices a great variety of modifications of the final substrate is possible. Another application of plug-in parts is their use for functional tests or as removable interconnection to external devices whereby for the latter case wires can be attached to a plug-in.

The bottom part of the multilayer substrate as shown in Fig. 5 is preferably built of a second set 23 of stacked layers which are formed similar to the first set, i.e. also consisting of sub-unit parts carrying wirings. As the backside of multilayer substrates typically comprise a plurality of contact pins 20 the lower layers and respective unit parts can be construed to have a larger shape thus revealing an enhanced mechanical stability.

Fig. 6 shows an enlarged cross-sectional view of the embodiment as presented in Fig. 5. Contact pins 20 are attached to the bottom layer of the lower stack 23 e.g. by soldering or brazing techniques. Preferably the sub-units used for building the layers of the lower stack are also consisting of monocrystalline silicon, which allows preparing of vias by means of anisotropical etching as already described. These vias can easily be made asymmetric by adjusting the respective front and backside mask. The remaining vias or holes then have the shape of square pyramids which can be used to hold the pins very tight as their basements 24 can be formed to fit into the respective recesses of the bottom layer. This reveals a self aligning effect during assembly of the pins and generates a connection which tolerates mechanical stresses.

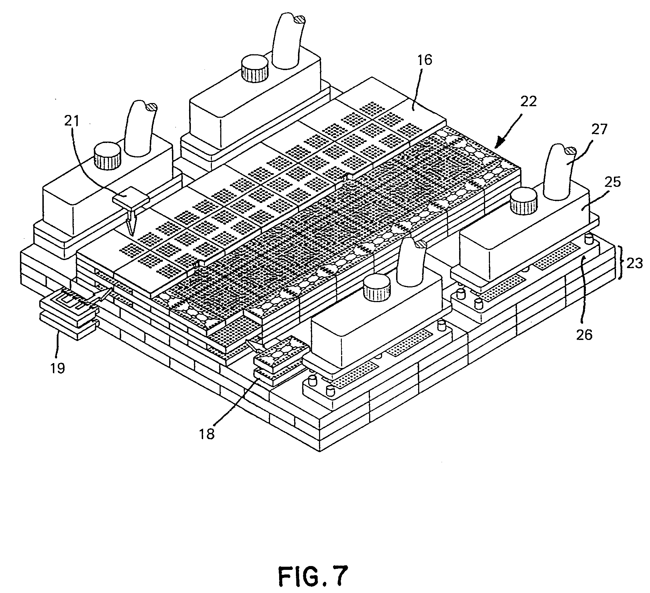

An alternative embodiment of the present invention is shown in Fig. 7, wherein the lower layer stack 23 of the multilayer substrate is extended over the side of the first layer stack 22. By implementing at least on plug-in socket 26 on the extended part of the lower layer the whole substrate can be electrically joined to a board or other devices by means of corresponding connectors 25 and the respective cables or bundles of wires 27. Thus the backside pin array can be replaced by the connector layout of this embodiment.

The extended part of the bottom layer stack 23 can also be enlarged so as to be capable of directly carrying additional multilayer stack parts 22 (not shown). Sets of individual multilayer stack parts 22 can be interconnected by a respectively dimensioned bottom layer stack 23, which replaces the prior art second level packaging boards.

**Claims**

1. A modular multilayer interwiring structure wherein each layer consists of planar wiring units (1) which are laterally placed together.

2. The modular multilayer interwiring structure according to claim 1 wherein said layers are electrically seperated by leaving a small distance between them filled with air or insulative material, preferably comprising $SiO_2$, $Si_3N_4$ or composition material.

3. The modular multilayer interwiring structure according to claim 1 or 2 wherein said layers are stacked in a way so that a lateral displacement occurs with respect to the vertical sequence of said planar units.

4. The modular multilayer interwiring structure according to any one of the preceding claims wherein said planar units are basically consisting of insulative material, preferably selected from ceramics, glasses, glas-ceramics or composition material.

5. The modular multilayer interwiring structure according to any one of claims 1 to 3 wherein said planar units are basically consisting of semiconducting material, preferably silicon.

6. The modular multilayer interwiring structure according to claim 5 wherein at least one of said planar units comprises electronic devices integrated thereon.

7. The modular multilayer interwiring structure according to any one of the preceding claims wherein said planar units comprise at least one individual interwiring layer (2) preferably formed by lithographic or thin film technology and consisting of conductive or superconducting material.

8. The modular multilayer interwiring structure according to any one of the preceding claims wherein said planar units comprise vertical wiring preferably including throughconnections (6) penetrating said planar units.

9. The modular multilayer interwiring structure according to claim 8 wherein said throughconnections are produced by LASER-techniques, drilling or etching, preferably by reactive ion etching (RIE) or anisotropic wet etching, or micro-electro-erosion.

10. The modular multilayer interwiring structure according to claim 8 or 9 wherein said throughconnections are filled with a conductive or a superconducting material, preferably copper.

11. The modular multilayer interwiring structure according to claim 10 wherein said conductive material is separated from the surrounding material of the unit by an insulative film (11), preferably consisting of $SiO_2$ or $Si_3N_4$.

12. The modular multilayer interwiring structure according to any one of the preceding claims wherein the plurality of said planar units comprise sets or arrays of surface contact pads (3), at least some of said contact pads being electrically connected to individual interwiring layers.

13. The modular multilayer interwiring structure according to claim 12 wherein preferably the plurality of said surface contact pads is formed as terminal parts of said penetrating throughconnections.

14. The modular multilayer interwiring structure according to claim 12 or 13 wherein at least some of said surface contact pads are protruding from the unit's surface in a manner as to work as distance holders between the stacked layers.

15. The modular multilayer interwiring structure according to claim 12, 13 or 14 wherein vertically neighboured units are physically and electrically connected (15) by brazing or soldering said contact pads.

16. The modular multilayer interwiring structure according to any one of the preceding claims wherein at least one side of the structure comprises recesses which serve as sockets for respective plug-in parts (19).

17. The modular multilayer interwiring structure according to any one of the preceding claims wherein a second layer stack (23) serves as basement or backside of the structure for carrying pins (20) and/or connector means (26).

18. A modular multilayer interwiring structure as recited in any one of the preceding claims additionally comprising internal channels for heat reduction e.g. by flow of coolant.

19. An electronic system, preferably a data processing system, wherein a modular multilayer substrate as recited in any one of the preceding claims is used as a carrier for integrated circuit chips or interwiring modules.

20. The system of claim 19, wherein said integrated circuit chips are selected out of the group comprising analoguous circuits or digital circuits, such as memory or logic devices.

21. The system of claim 19 or 20, including cooling means to provide a coolant to be circulated through the channels in a modular multilayer substrate in accordance with claim 18.

FIG. 1

EP 0 516 866 A1

PRIOR ART
(MLC)

103

3

5

FIG. 2

FIG. 3

FIG. 4

10

FIG.5

FIG.6

FIG.7

# EUROPEAN SEARCH REPORT

European Patent Office

Application Number

EP 91 10 7214

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4 990 462 (J. SLIWA JR.)<br><br>* column 21, line 5 - column 23, line 51 *<br>* column 27, line 52 - column 28, line 9 *<br>* column 29, line 38 - column 30, line 45; figures 5,16A,B,17,20 * | 1,2,<br>5-16,19,<br>20 | H01L23/538<br>H01L23/473<br>H01L25/065 |
| X | EP-A-0 073 486 (TOSHIBA CORP.)<br><br>* the whole document * | 1,2,5,6,<br>8,19,20 | |
| X | EP-A-0 315 792 (FORD AEROSPACE CORP.)<br><br>* the whole document * | 1,4,12,<br>15,16,<br>18,19 | |
| X | EP-A-0 285 064 (HITACHI LTD.)<br><br>* the whole document * | 1,4,7,<br>12,13,19 | |
| A | EP-A-0 378 016 (THOMSON CSF.)<br><br>* the whole document * | 1,4,7,<br>18,19,21 | TECHNICAL FIELDS SEARCHED (Int. Cl.5 )<br><br>H01L |
| A | EP-A-0 267 360 (INTERNATIONAL BUSINESS MACHINES CORP.)<br>* the whole document * | 1-21 | |
| A | US-A-4 631 636 (D. ANDREWS)<br>* figures 2,3 * | 14 | |
| A | EXTENDED ABSTRACTS. / SPRING MEETING 88-1<br>vol. 15, no. 20, May 1988, PRINCETON, NEW JERSEY US<br>pages 66 - 67;<br>C. TING: 'SILICON INTERCONNECTION SUBSTRATES FOR MULTICHIP PACKAGING'<br>* the whole document * | 1,6,7 | |

The present search report has been drawn up for all claims

| Place of search | Date of completion of the search | Examiner |
|---|---|---|
| THE HAGUE | 14 JANUARY 1992 | ZEISLER P.W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)